# EUROPÄISCHE PATENTANMELDUNG

(11) **EP 0 543 270 A2**
(43) Veröffentlichungstag der Anmeldung: **26.05.1993**
(21) Anmeldenummer: 92119285.2
(22) Anmeldetag: 11.11.1992
(51) Int. Cl.: H05K 3/34, B23K 1/005, B23K 1/012, B23K 3/047

(54) **Lötvorrichtung zum Ein- und Auslöten von elektronischen Bauelementen**

(30) Priorität: 11.11.1991 DE 9113986 U
(71) Anmelder: ZEVAC AUSLÖTSYSTEME GmbH, D-34442 Arolsen (DE)
(72) Erfinder: Paul Jörns, Ing.-Grad, 3548 Arolsen (DE)
(74) Vertreter: Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.)

(57) **Zusammenfassung**

Bei Ein - und Auslötvorrichtungen soll eine Temperaturregelung unmittelbar an der Lötverbin - dung dadurch verwirklicht werden, daß ein Pyrome - ter auf die Lötverbindung gerichtet und damit deren Temperatur zur Schaffung einer Regelungsmög - lichkeit gemessen wird.

## Beschreibung

Die Erfindung betrifft eine Lötvorrichtung nach dem Oberbegriff des Patentanspruchs 1.

Derartige, auch unter der Bezeichnung Ein - und Auslötgeräte bekannte Lötvorrichtungen dienen dazu, schadhafte elektronische Bauelemente aus einer Leiterplatte auszulöten oder neue und intakte Bauelemente auf einer Leiterplatte anzu - ordnen und in diese einzulöten (siehe z.B. EP-A1 - 0309665; GB-A-21 54 921; US-A- 4 295 596; GB-A-21 81 981). Der Heiz-Haltekopf dient dabei sowohl zum Erhitzen der Lötstellen beispielsweise durch Zufuhr von Heißluft als auch zum Festhalten des Bauelements beispielsweise durch Vakuum beim Aufsetzen auf die Leiterplatte bzw. Entfernen von ihr. Zu diesem Zweck ist der Heiz-Haltekopf heb - und senkbar sowie ggf. auch schwenkbar am Grundgestell angeordnet.

Im allgemeinen ist auch noch eine optische Beobachtungsvorrichtung, beispielsweise in Form eines Stereomikroskops am Grundgestell angeordnet, mit welcher das in der Halterung angeord - nete Bauelement während der verschiedenen Manipulationen beobachtet werden kann.

Ein Problem bei derartigen Lötvorrichtungen besteht darin, die Temperatur an den Lötstellen abzuschätzen, um einerseits die der gewünschten Temperatur entsprechende Heizgasmenge zufüh - ren zu können und andererseits rechtzeitig zu erkennen, wenn die Löttemperatur erreicht wird.

Zu diesem Zweck ist es bereits bekannt (EP - A1 - 0 309 665), innerhalb des Heiz - Haltekopfes möglichst nahe der Lötstelle ein Thermoelement anzuordnen, mittels dessen eine Temperaturmes - sung stattfindet. Nachteilig an dieser bekannten Lötvorrichtung ist, daß durch Messung der Tem - peratur innerhalb des Heiz - Haltekopfes nur auf die Temperatur der Lötstelle rückgeschlossen werden kann, ohne daß diese exakt bestimmt wird.

Das Ziel der vorliegenden Erfindung besteht darin, eine Lötvorrichtung der eingangs genannten Gattung zu schaffen, mit welcher die Temperatur unmittelbar an der Lötstelle exakt bestimmt werden kann.

Zur Lösung dieser Aufgabe sind die Merkmale des kennzeichnenden Teils des Anspruchs 1 vorgesehen.

Im allgemeinen genügt ein Pyrometer, doch könnte es zur Feststellung der Temperatur an verschiedenen Stellen des Bauelementes oder der Leiterplatte zweckmäßig sein, zwei Pyrometer vorzusehen.

Bei einem Pyrometer handelt es sich um ein optisches Instrument, welches die von einem in einem bestimmten Abstand angeordneten Gegen - stand ausgehende Infrarotstrahlung beispielsweise durch eine Infrarotstrahlung durchlassende Linse auf ein infrarotempfindliches Photoelement kon - zentriert, das ein für die Temperatur an der Meß - stelle repräsentatives elektrisches Ausgangssignal abgibt.

Auf diese Weise kann nicht nur die Temperatur an der Lötstelle exakt gemessen werden, sondern es kann darüber hinaus das Pyrometer auf jede gewünschte Stelle des zu lötenden Bauelements ausgerichtet werden, so daß ganz gezielt die Temperatur an jeder gewünschten Stelle exakt bestimmt werden kann.

Nach Anspruch 2 ist das Pyrometer bevorzugt an einem am Grundgestell angeordneten Tragarm befestigt, stellt also einen mit der Lötvorrichtung eine bauliche Einheit dar.

Besonders bevorzugt wird das Pyrometer zu - sammen mit einer optischen Beobachtungsvorrichtung verwendet, wobei das Pyrometer und die Lötstellen - Beobachtungsvorrichtung zweckmäßi - gerweise in unmittelbarer Nachbarschaft angeord - net sind, weil sie vom gleichen Gegenstand Strah - lung empfangen sollen, und zwar das Pyrometer die Infrarotstrahlung und das optische Beobach - tungsgerät die im optischen Wellenlängenbereich liegende Strahlung.

Besonders bevorzugt ist es, wenn das Pyrometer an demselben Tragarm mitbefestigt wird, an dem bereits die Lötstellen - Beobachtungsvorrich - tung angeordnet ist, und zwar vorzugsweise in ei - nem bestimmten Winkelbereich mit dem Zentrum am Bauelement verstellbar.

Vorteilhafterweise ist das Pyrometer in der durch die Ansprüche 4 und 5 gekennzeichneten Weise verschwenkbar angeordnet, so daß es auf jede gewünschte Stelle des zu lötenden Bauele - ments ausrichtbar ist.

Bevorzugt wird erfindungsgemäß ein durch die Ansprüche 7 und 8 definiertes Pyrometer verwen - det, welches eine äußerst feine Auflösung dses Temperatur-Meßbereiches gewährleistet, wie das für die Temperaturbestimmung an ganz bestimm - ten individuellen Stellen des Bauelements insbe - sondere an den Lötfahnen zweckmäßig ist.

Soll nun gleichzeitig oder alternativ auch eine Temperatur - Mittelwertbildung über bestimmte größere Bereiche des Bauelementes erfolgen, so kann der Meßachse des Pyrometers beispielsweise durch einen eingebauten Schwingspiegel od.dgl. eine Abtastbewegung gemäß Anspruch 9 erteilt werden.

Mit dem Pyrometer kann auch durch die Maß - nahmen des Anspruches 10 eine automatische Temperaturregelung dergestalt stattfinden, daß an einem Sollwertgeber des Steuergeräts eine vorbestimmte Temperatur eingestellt wird und daß das Steuergerät dann in Abhängigkeit von der durch das Pyrometer erfolgenden lst-Wert-Messung den Heißgasstrom geschwindigkeits - oder temperaturmäßig so steuert, daß die eingestellte Soll - temperatur stets aufrechterhalten bleibt bzw. nicht überschritten wird.

Durch Verwendung eines Computers kann auch jedes gewünschte Temperaturprofil des Heißgases und/oder der Lötverbindung verwirklicht werden.

Erfindungsgemäß ist es erstmals möglich, eine derartige Lötvorrichtung personenunabhängig zu betreiben.

Ein besonderer Vorteil der Erfindung besteht darin, daß auch Temperatur-Zeit-Profile erfaßt werden können. So kann z.B. beim Abkühlen einer Lötschmelze durch Ablesen der Temperatur und nicht oder nicht allein durch optische Beobachtung der Erstarrungszeitpunkt festgestellt werden. Ein derartiges Meßverfahren ist ebenfalls Gegenstand der Erfindung.

Weiter sieht die Erfindung vor, daß in Abhän - gigkeit von der Temperatur z.B. beim Abkühlen bestimmte Funktionen, wie das Anstellen eines Kühlgebläses nach der Erstarrung der Schmelze, ausgelöst werden.

Durch die Abtastung kann auch die Temperatur an unterschiedlichen Stellen ermittelt werden. Stellt sich dabei z.B. heraus, daß unterschiedliche Teile des Bauelementes sehr unterschiedlich erhitzt werden, kann dies Anlaß zur Änderung des Layouts sein.

Das statisch arbeitende Pyrometer wird vorteilhafterweise auf eine solche Stelle des Bauele - mentes ausgerichtet, wo die Schmelztemperatur gegenüber anderen Stellen am spätesten erreicht wird.

Die Erfindung wird im folgenden beispielsweise anhand der Zeichnung beschrieben; in dieser zeigt:
Fig. 1 eine schematische Seitenansicht einer erfindungsgemäßen Lötvorrichtung mit einem optischen Lötstellen - Beob - achtungsgerät und einem Temperaturmeß - Pyrometer und
Fig. 2 eine entsprechende Seitenansicht wie Fig. 1 von der entgegengesetzten Seite, wobei das Pyrometer detail - lierter dargestellt ist, während die übrigen Bauteile nur schematisch und zum Teil nicht maßstabsgerecht gestrichelt angedeutet sind.

In beiden Figuren kennzeichnen gleiche Bezugszahlen entsprechende Bauteile.

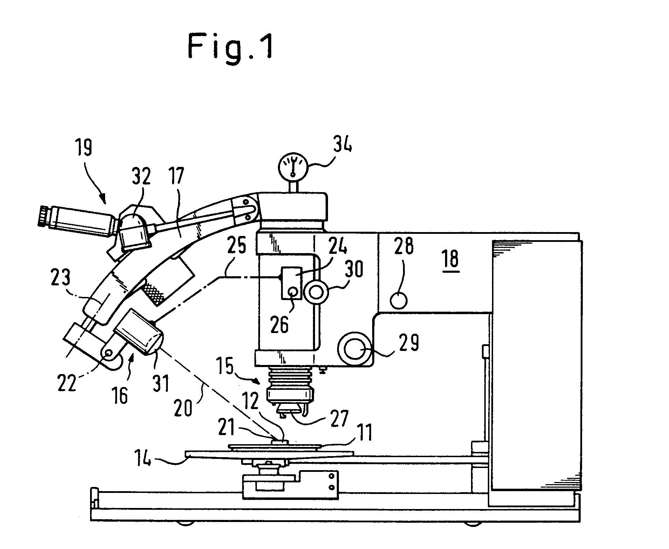

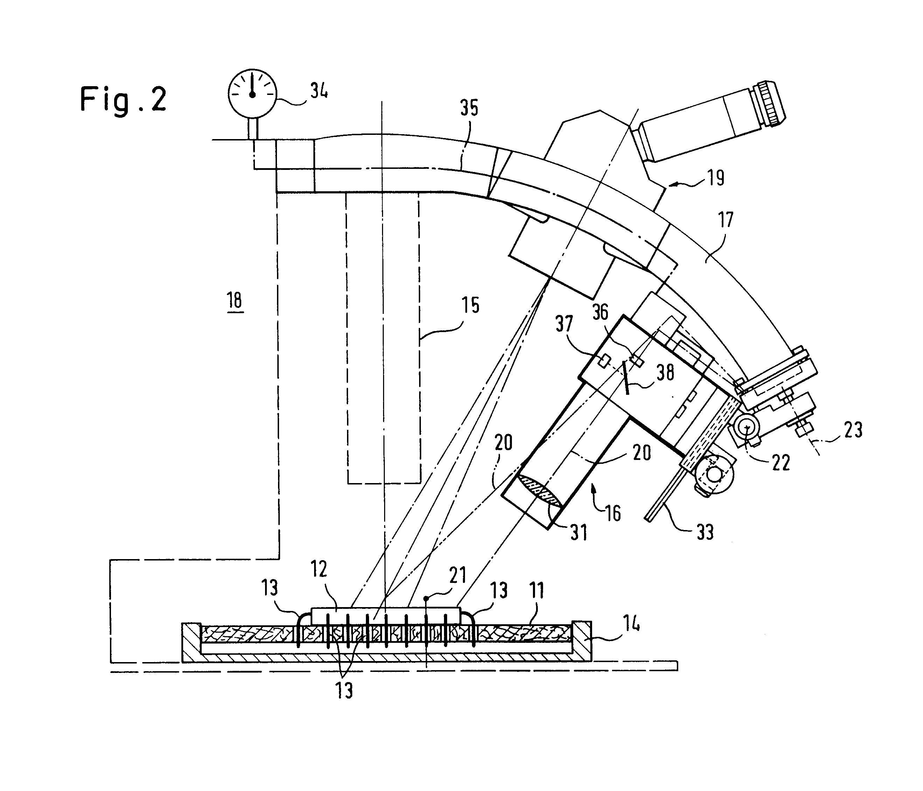

Nach Fig. 1 ist an einem im wesentlichen die Form eines liegenden U aufweisenden Grundgestell 18 unten eine Halterung 14 für eine wenigstens ein ein - oder auszulötendes elektronisches Bauelement 12 tragende Leiterplatte 11 vorgesehen. Nach Fig. 2 kann diese Halterung 14 als eine Klemme ausgebildet sein, die die Leiterplatte 11 einspannt und relativ zum Grundgestell 18 in einer horizontalen Ebene in nicht im einzelnen dargestellter Weise verschieb- und ggf. auch verschwenkbar ist.

Oberhalb der Halterung 14 ist ein Heiz - Hal - tekopf 15 angeordnet, der an seinem unteren Ende eine Heizgas-Austrittsdüse 27 trägt, an die auch ein Vakuum angelegt werden kann, um das aus - gelötete Bauelement 12 von der Leiterplatte 11 abziehen zu können. Zur Anlegung des Vakuums an die Düse 27 ist am Grundgestell 18 eine Vaku - umtaste 28 vorgesehen.

Mittels eines Verstellknopfes 29 kann der Heiz - Haltekopf 15 bis zum Bauelement 12 abge - senkt und dann wieder angehoben werden. Ein weiterer Verstellknopf 30 ermöglicht auch noch eine Winkelverstellung des Heiz - Haltekopfes 15 in einem bestimmten Winkelbereich.

Am oberen Schenkel des Grundgestells 18 ist oberhalb des Heiz - Haltekopfes 15 ein vorzugsweise doppelt ausgebildeter Haltearm 17 angeordnet, der sich mit dem Mittelpunkt im Bereich des Bauelementes 12 kreisförmig nach unten gebogen vor das Grundgestell 18 erstreckt. An die - sem Doppeltragarm 17 ist eine als Stereomikro - skop ausgebildete optische Lötstellen - Beobach - tungsvorrichtung 19 angeordnet, und zwar in der Weise, daß sie entlang der durch den Doppeltragarm 17 definierten Kreisbahn verstellbar ist. Auf diese Weise kann das Bauelement 12 durch die Lötstellen - Beobachtungsvorrichtung 19 aus verschiedenen Richtungen betrachtet werden, ohne daß sich der Vergrößerungsfaktor oder die Schärfe verändert.

Am vorderen Ende des gleichen Doppeltragarms 17 ist ein Pyrometer 16 um zwei senkrecht aufeinanderstehende Achsen 22,23 schwenkbar angeordnet, und zwar derart, daß seine Meßachse 20 auf das Bauelement 12 der in die Halterung 14 eingespannten Leiterplatte 11 gerichtet ist. Die Frontlinse 31 des Pyrometers 16 konzentriert die von einem schmalen Meßbereich 21 stammende Infrarotstrahlung auf einem nicht dargestellten in - frarotempfindlichen Photoelement.

Nach Fig. 2 kann das Pyrometer 16 zusätzlich über eine Linearführung 33 in Richtung auf die Halterung 14 zu - bzw. von ihr wegbewegt werden.

Diese Maßnahme dient zur Veränderung des erfaßten Meßbereiches 21.

Das elektrische Ausgangssignal des Pyrome - ters 16 ist nach Fig.1 über eine strichpunktiert angedeutete Steuerleitung 25 mit einem im Gestell 18 angeordneten Steuergerät 24 verbunden, wel - ches einen Temperatur - Sollwert - Einstellknopf 26 aufweist.

Es ist zu betonen, daß zwar die Lötstellen - Beobachtungsvorrichtung 19 entlang des kreisförmig gekrümmten Doppeltragarmes 17 verschiebbar ist, um die Beobachtungsposition verändern zu können, daß jedoch das Pyrometer 16 am freien Ende der Doppeltragarme 17 bis auf die Verschwenkungsmöglichkeit um die Achsen 22,23 und die Verschiebbarkeit entlang der Führung 31 fest, also nicht entlang der Tragarme 17 verschiebbar angebracht ist. Auf diese Weise wird der Verschwenkbereich der Lötstellen - Beobachtungs - vorrichtung 19 nicht eingeengt, während gleichwohl das Pyrometer 16 aus einer optimalen Position heraus die vom Bauelement 12 ausgehende Infrarotstrahlung empfangen kann. Durch Anordnung an dem Tragarm 17 wird auch die Handhabung des Gerätes kaum beeinträchtigt, zumal es besonders bevorzugt ist, wenn sich das Pyrometer 16 im Endbereich des Tragarms 17 innerhalb von dessen Kreisbahn befindet, wie das aus den Fig. 1 und 2 hervorgeht.

Seitlich am hinteren Ende des Tragarms 17 können beidseitig verstell- bzw. verschwenkbare Beleuchtungskörper 32 angeordnet sein.

Am Schaltpult des Grundgestells 18 ist ein in den Fig.1 und 2 nur schematisch angedeutetes Temperaturmeßinstrument 34 angebracht, welches gemäß Fig. 2 durch eine strichpunktiert angedeu - tete Leitung 35 mit dem Pyrometer 16 verbunden ist.

Die Funktion der beschriebenen Lötvorrichtung ist wie folgt:
Beim Auslöten eines Bauelements 12 aus einer Leiterplatte 11 wird letztere zunächst in die Halte - rung 14 eingespannt, welche dann unter Beobachtung durch die Lötstellen-Beobachtungsvorrichtung 19 durch Horizontalverschiebung oder Verschwenkung in einer Horizontalebene in der gewünschten Weise optimal zum Heiz - Haltekopf 15 ausgerichtet wird. Anschließend wird dann die Achse 20 des Pyrometers 16 gemäß Fig. 2 durch Verschwenkung um die Achsen 22,23 exakt auf den gewünschten Meßbereich 21 ausgerichtet und ggf. auch eine Linearverschiebung entlang der Führung 33 vorgenommen, um die Größe des Meßbereichs 21 einzustellen. Dies kann Z.B. dadurch geschehen, daß im Pyrometer 16 neben dem Empfangsphotoelement 36 eine Leuchtdiode 37 angeordnet ist, die über einen Strahlenteilerspiegel 38 in den Strahlengang eingekoppelt ist und somit einen dem Empfangsstrahl entsprechenden Sendestrahl aussendet, der als mehr oder weniger scharfer Lichtpunkt auf der Oberfläche des Bauelements 12 erscheint. Auf diese Weise kann die Meßachse 20 des Pyrometers 16 auf jeden gewünschten Punkt des Bauelementes 12 bzw. der Lötfahnen 13 ausgerichtet und die Größe des Meßbereiches 21 gewählt werden. Der Schwenkbereich des Pyrometers 16 bzw. seiner Meßachse 20 in beiden Ebenen beträgt beim Ausführungsbeispiel nach Fig.2 9°. Dadurch kann der vom Pyrometer 16 erfaßte Meßbereich mit einem Durchmesser von ca. 1 mm um jeweils 3 cm in allen Richtungen vom dargestellten mittleren Meßbereich 21 verschoben werden.

Nach Einschalten des Pyrometers 16 wird nunmehr die Temperatur des vom Pyrometer 16 anvisierten Meßbereichs auf dem Temperaturmeßinstrument 34 angezeigt.

Nunmehr wird durch Drehen am Einstellknopf 29 der Heiz - Haltekopf 15 auf die Leiterplatte 11 abgesenkt, und das die Erhitzung auf beispiels - weise 450 ° C vornehmende und in der Zeichnung nicht dargestellte Heizgebläse wird eingeschaltet, worauf aufgrund geeigneter Ausbildung der Heiz - düse 27 die Lötstellen zwischen den Lötfahnen 13 und den Leiterbahnen der Leiterplatte 11 langsam aufgeheizt werden. Die Temperatur des anvisierten Meßbereichs, insbesondere einer bestimmten Lötfahne 13 kann dabei auf dem Meßinstrument 34 verfolgt werden.

Sobald die Verflüssigungstemperatur des verwendeten Lotes erreicht ist, kann die Vakuumtaste 28 gedrückt und auf diese Weise das Bauelement 12 von der mit einer entsprechenden Ansaugvorrichtung versehenen Düse 27 angesaugt und dann durch Hochfahren des Heiz - Haltekopfes 15 aus der Leiterplatte 11 entfernt werden.

Das Einlöten geht in umgekehrter Reihenfolge vor sich, wobei durch Beobachtung des Meßin - struments 34 das Überschreiten einer bestimmten Temperatur am anvisierten Meßbereich 21 verhin - dert werden kann, indem der Heizgasstrom in geeigneter Weise rechtzeitig gedrosselt oder abge - stellt wird.

Die Meßachse 20 des Pyrometers 16 kann beispielsweise durch einen eingebauten Schwenkspiegel auch zu einer Abtastbewegung und vor allen Dingen zu einer linearen, kreisförmigen, el - liptischen, zeilenweise oder sonstwie geeigneten Abtastbewegung veranlaßt werden, so daß der Mittelwert der Temperatur über den abgetasteten Bereich vom Meßinstrument 34 angezeigt wird.

Ein Meß - und Steuerverfahren zur Konstant - haltung der Löttemperatur bzw. zur Vermeidung der Überschreitung einer vorbestimmten Löttemperatur kann darin bestehen, daß das elektrische Ausgangssignal des Pyrometers 16 nicht nur auf das Temperaturmeßinstrument 34, sondern auch an über eine Steuerleitung 25 an ein irgendwo im Gestell 18 angeordnetes Steuergerät 24 geliefert wird, welches den Einstellknopf 26 für eine Soll - temperatur aufweist. Das Steuergerät 24 arbeitet so, daß die vom Pyrometer 16 gemessene Isttem - peratur ständig mit der ham Einstellknopf 26 ein - gestellten Solltemperatur verglichen wird. Sobald die Solltemperatur, die der optimalen Löttemperatur entsprechen sollte, erreicht ist, wird durch nicht gezeigte Steuermittel der Heizgasstrom so gedrosselt oder zeitweise abgeschaltet, daß die vorgeschriebene und voreingestellte Löttemperatur nicht überschritten wird.

Die Erfindung schafft somit erstmals eine Ein - und Auslötvorrichtung, die eine wertmäßig und/oder örtlich exakte Temperaturkontrolle, - steuerung und/oder - regelung möglich macht. Dadurch kann der für eine erfolgreiche Lötung besonders wichtige Faktor der Löttemperatur opti - miert werden, was nicht nur das Lötergebnis verbessert, sondern auch zu reproduzierbaren Resul - taten führt.

## Patentansprüche

1. Lötvorrichtung zum Ein - und/oder Auslöten von auf Leiterplatten (11) anzuordnenden bzw. angeordneten elektronischen Bauelementen (12) mit an die Leiterplatten (11) anzulötenden bzw. angelöteten Lötfahnen (13), welche eine vorzugsweise in der Ebene der Leiterplatte (11) verschieb - und/oder verschwenkbare Halterung (14) zur räumlich definierten Anord - nung der Leiterplatte (11), einen oberhalb der Halterung (14) angeordneten, zum Bauelement (12) hin - und von ihm wegbewegbaren sowie ggf. schwenkbaren Heiz-Haltekopf (15), der in eine vorbestimmte Position am Bauelement (12) bringbar ist und Heizmittel zum Erhitzen der Lötfahnen (13), insbesondere durch Heißluftzufuhr, sowie eine insbesondere mit Vaku - um arbeitende Haltevorrichtung für das Bau - element (12) aufweist, wobei eine Temperaturmeßvorrichtung (16) für die Messung der Temperatur im Bereich der Lötstellen vorgesehen ist,
dadurch gekennzeichnet,
daß die Temperaturmeßvorrichtung wenigstens ein Pyrometer (16) ist, welches in einem Abstand oberhalb der die Leiterplatte (11) aufnehmenden Halterung (14) angeordnet und auf die Lötstelle bzw. die Lötstellen ausgerichtet ist.

2. Lötvorrichtung nach Anspruch 1,
dadurch gekennzeichnet,
daß das Pyrometer (16) an einem am Grund - gestell (18) angeordneten Tragarm (17) befestigt ist.

3. Lötvorrichtung nach Anspruch 1 oder 2, bei dem vorzugsweise am gleichen Tragarm (17) auch eine optische Lötstellen - Beobach - tungsvorrichtung (19) vorgesehen ist,
dadurch gekennzeichnet,
daß das Pyrometer (16) in unmittelbarer Nachbarschaft zur optischen Lötstellen - Be - obachtungsvorrichtung (19) angeordnet ist.

4. Lötvorrichtung nach einem der vorhergehen - den Ansprüche,
dadurch gekennzeichnet, daß die Meßachse (20) des Pyrometers (16) relativ zur Halterung (14) in einem vorbestimmten Winkelbereich, insbesondere Raumwinkelbereich, der vorzugsweise in der Größenordnung von 10 ° liegt, verstellbar ist.

5. Lötvorrichtung nach Anspruch 4,
dadurch gekennzeichnet,
daß das Pyrometer (16) um zwei senkrecht aufeinanderstehende Achsen (22, 23) verschwenkbar ist.

6. Lötvorrichtung nach einem der vorhergehen - den Ansprüche,
dadurch gekennzeichnet,
daß das Pyrometer (16) in Richtung zur Hal - terung (14) verstellbar ist.

7. Lötvorrichtung nach einem der vorhergehen - den Ansprüche,
dadurch gekennzeichnet,
daß der vom Pyrometer (16) erfaßte Meßbe - reich (21) eine so geringe Ausdehnung aufweist, daß es die Temperatur an nur einer der Lötfahnen (13) erfassen kann.

8. Lötvorrichtung nach Anspruch 7,
dadurch gekennzeichnet,
daß der Meßbereich (21) eine Dimension, ins - besondere einen Durchmesser von etwa 1 mm aufweist.

9. Lötvorrichtung nach einem der vorhergehen - den Ansprüche,
dadurch gekennzeichnet,
daß die Meßachse (20) des Pyrometers (16) innerhalb eines vorbestimmten Winkelberei - ches zu einer Abtastbewegung, die linear, kreisförmig, elliptisch oder zeilenweise sein kann, veranlaßbar ist.

10. Lötvorrichtung nach einem der vorhergehenden Ansprüche,
dadurch gekennzeichnet,
daß das für die gemessene Temperatur im Meßbereich (21) repräsentative Ausgangssi - gnal des Pyrometers (16) an ein Steuergerät (24) angeschlossen ist, welches die Heizmittel auf eine am Steuergerät (24) voreingestellte (26) Löttemperatur einstellt.

11. Verfahren zur Temperaturregelung mit einer Lötvorrichtung nach einem der vorhergehen - den Ansprüche,
dadurch gekennzeichnet,
daß die vom Pyrometer unmittelbar an der Lötverbindung gemessene Temperatur zur Regelung der Geschwindigkeit und/oder Temperatur des Heißgasstromes in dem Sinne verwendet wird, daß an der Lötverbindung eine vorbestimmte Solltemperatur aufrechterhalten oder überschritten wird.
